# EUROPEAN PATENT APPLICATION

(11) **EP 3 893 609 A1**
(43) Date of publication of application: **13.10.2021**
(21) Application number: 20168700.1
(22) Date of filing: 08.04.2020
(51) Int. Cl.: H05K 1/02, H05K 1/14, H05K 3/00

(54) **FAILURE ROBUST BENDING OF COMPONENT CARRIER WITH RIGID AND FLEXIBLE PORTION CONNECTED WITH A ROUNDING**

(71) Applicant: AT & S Austria Technologie & Systemtechnik Aktiengesellschaft, 8700 Leoben-Hinterberg (AT)
(72) Inventor: Frewein, Markus, 8700 Leoben (AT)
(74) Representative: Dilg, Haeusler, Schindelmann Patentanwaltsgesellschaft mbH

(57) **Abstract**

A partially rigid and partially flexible component carrier (100), wherein the component carrier (100) comprises a rigid portion (102) comprising a first stack (104) having at least one first electrically conductive layer structure (106) and/or at least one first electrically insulating layer structure (108), and a flexible portion (110) comprising a second stack (112) having at least one second electrically conductive layer structure (114) and/or at least one second electrically insulating layer structure (116), wherein a transition portion (118) at an interface between the rigid portion (102) and the flexible portion (110) is rounded for reducing bending stress.

## Description

### Field of the Invention

The invention relates to a partially flexible and partially rigid component carrier, and a method of manufacturing a partially flexible and partially rigid component carrier.

### Technological Background

Component carriers and electronic components mounted thereon and/or embedded therein are in wide use in electronic products. By employing partially flexible and partially rigid component carriers which comprise a rigid portion and a flexible or semi-flexible portion, the advantages of both a rigid component carrier and a flexible component carrier may be combined. Increasing miniaturization and growing product functionalities as well as a rising number of electronic components to be mounted on the component carriers, such as printed circuit boards, lead to more densely packed electronic devices, wherein an increasing number of electrical contacts has to be connected.

Bending a partially rigid and partially flexible component carrier may cause high mechanical load between a rigid portion and a flexible portion as well as within the flexible portion of the partially rigid and partially flexible component carrier, may limit the lifetime of such component carriers, and may even damage the component carrier.

### Summary of the Invention

There may be a need for a component carrier with rigid portion and flexible portion which is mechanically reliable even under harsh conditions and which is bendable with reduced risk of damage.

According to an exemplary embodiment of the invention, a partially rigid and partially flexible component carrier is provided, wherein the component carrier comprises a rigid portion comprising a first stack having at least one first electrically conductive layer structure and/or at least one first electrically insulating layer structure, and a flexible portion comprising a second stack having at least one second electrically conductive layer structure and/or at least one second electrically insulating layer structure, wherein a transition portion at an interface between the rigid portion and the flexible portion is rounded for reducing bending stress.

According to another exemplary embodiment of the invention, a method of manufacturing a partially rigid and partially flexible component carrier is provided, wherein the method comprises forming a rigid portion comprising a first stack having at least one first electrically conductive layer structure and/or at least one first electrically insulating layer structure, forming a flexible portion comprising a second stack having at least one second electrically conductive layer structure and/or at least one second electrically insulating layer structure, and forming a transition portion at an interface between the rigid portion and the flexible portion with a rounding for reducing bending stress.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be a partially rigid and partially flexible component carrier, such as a printed circuit board, an organic interposer, and an IC (integrated circuit) substrate. A component carrier may also be a hybrid board combining different ones of the above mentioned-types of component carriers.

In the context of the present application, the term "rigid portion" may particularly denote a portion of the component carrier which, when applying or exerting ordinary forces typically occurring during operation of the component carrier, the rigid portion will remain substantially undeformed. In other words, the shape of the rigid portion will not be changed when applying forces during operation of the component carrier.

In the context of the present application, the term "flexible portion" may particularly denote a portion of the component carrier which, upon exerting typical forces occurring during operation of the component carrier, will result in a deformation of the flexible portion. The deformation of the flexible portion may be possible to such an extent that the shape of the entire component carrier may be significantly influenced by deforming the flexible portion. The flexible portion may be elastic, repeatedly bendable or bendable only once (for instance in the case of a semi-flexible material property of the flexible portion).

In the context of the present application, the term "transition portion at an interface between a rigid portion and a flexible portion" may particularly denote a portion of a component carrier connecting the rigid portion with the flexible portion. In particular, the transition portion may also be a bending portion, i.e. a portion at which the partially rigid and partially flexible component carrier is to be bent or has been bent.

In the context of the present application, the term "rounded transition portion" may particularly denote that an edge of the transition portion is not embodied as a vertical step and is also not straight, but that this transition portion has a curvature at the interface between rigid portion and flexible portion. The transition portion may in particular be continuous and may have an exterior edge, which changes its shape without sharp 90°-step.

According to an exemplary embodiment of the invention, a partially rigid and partially flexible component carrier is provided, which is reliably protected from being damaged or deteriorated upon bending at a transition portion between a flexible portion and a rigid portion thanks to the provision of a rounding at this interface. Conventionally, the highest load upon bending may be exerted at the transition portion where bending occurs. However, according to an exemplary embodiment of the invention, such an excessive load at the transition portion where bending occurs may be efficiently suppressed by providing a rounding at the rigid-flexible-interface. With such a curved geometry around a bending position, excessive bending stress may be prevented, as confirmed by finite element simulations. Descriptively speaking, any peak of mechanical load at the transition portion may be avoided by establishing such a rounding rather than a sharp step. Hence, the mechanical reliability of the partially flexible and partially rigid component carrier may be significantly improved. The described provision for preventing bending failure may be manufactured with very low effort, since the mere formation of a rounded or curved transition portion may be sufficient.

### Detailed Description of Exemplary Embodiments

In the following, further exemplary embodiments of the method and the component carrier will be explained.

In a preferred embodiment, the transition portion is rounded in such a way that the rounding reduces a bending stress at a bending point at the transition portion as compared to a non-rounded (in particular horizontally or vertical, in a plan view of the component carrier along a stacking direction of layer structures thereof) transition between the rigid portion and the flexible portion. A finite element analysis has confirmed such a bending stress reduction as a consequence of providing a rounding between a rigid portion and a flexible portion of the component carrier.

In an embodiment, at least one of the at least one first electrically conductive layer structure and at least one of the at least one second electrically conductive structure form a common (in particular connected) coplanar (i.e. arranged within the same plane) electrically conductive layer structure. In other words, at least one metallic layer structure may be continuous between the rigid portion and the flexible portion. Such a continuous layer has also turned out to have a positive impact on the suppression of cracks, breakage or other failure mechanisms at the transition portion.

In an embodiment, at least one of the at least one first electrically insulating layer structure and at least one of the at least one second electrically insulating structure form a common (in particular connected) coplanar (i.e. arranged within the same plane) electrically insulating layer structure. As described in the preceding paragraph for the continuous electrically conductive layer structure, additionally or alternatively an electrically insulating layer structure may be continuously extending from the rigid portion up to the flexible portion. Also such a continuous dielectric layer connecting and extending along both portions may have a positive impact on the protection of the partially rigid and partially flexible component carrier against bending failure.

In an embodiment, the component carrier is configured as rigid-flex component carrier in which electrically insulating material of the flexible portion is different from electrically insulating material of the rigid portion. For example, the rigid-flex component carrier comprises a fully flexible portion, for instance made of polyimide (for instance having an ultimate strain of about 70%). In such an embodiment, the material of the flexible portion may be different from the material of one or two adjacent rigid portions, and the material of the flexible portion may be specifically selected to have high elasticity or flexibility. A thickness of the flexible portion and of the rigid portion may then be the same. In such a rigid-flex component carrier, the flexibility of the flexible portion may result from a material selection in particular of dielectric layers in this flexible portion. For instance, such a dielectric material may be polyimide. In contrast to this, dielectric material of the rigid portion may, for instance, be FR4.

In another embodiment, the component carrier is configured as semi-flex component carrier in which electrically insulating material of the rigid portion and of the flexible portion is the same. A semi-flex component carrier may be provided with a semi-flexible portion, for instance made of FR4 material. In such a configuration, the semi-flexible portion may be made of the same material as one or two adjacent rigid portions, but may for instance only have a locally smaller thickness than the connected rigid portion(s). In such a configuration, bendability of the flexible portion only results from the reduced thickness rather than from a more flexible material in the flexible portion. A thickness of the flexible portion may be smaller than a thickness of the rigid portion. A semi-flex component carrier obtains its flexibility in the flexible portion only from the fact that the number of layer structures in the flexible portion is smaller than the number of layer structures in the rigid portion. The materials in the rigid and the flexible portion, however, may be the same in a semi-flex component carrier. Also in a semi-flex component carrier the curvature in a transition portion significantly reduces the risk of a bending failure.

In an embodiment, the transition portion has a rounding defined by a radius, in particular defined by a single radius. In other words, a circular rounding may be provided at the transition portion. Such a circular rounding has turned out as highly efficient for avoiding breakage upon bending at the transition portion. At the same time, a rounding defined by a radius may be easily manufactured.

In an embodiment, the radius is smaller than 1 mm, in particular smaller than 0.5 mm. Highly advantageously, already a relatively small radius of the curved or rounded transition portion has a pronounced impact on the protection of the component carrier against failure during bending. Advantageously, already a radius smaller than 1 mm may significantly reduce stress in the most critical transition region and may therefore enhance the final robustness of the component carrier with low space consumption. Preferably, the radius is larger than 0.1 mm for obtaining a particularly pronounced increase of the resistance against bending failure.

In an embodiment, the transition portion is defined by a first radius followed by a second radius. In one embodiment, the first radius and the second radius may be connected to form an S-shape. In another embodiment, the first radius and the second radius may be connected to form a continuous convex-concave shape for instance having a 45° tangent in a convex-concave transition region. Also the combination of two (or more) curved sections, each being defined by a respective radius, has turned out as a reliable protection against bending failure. The two (or more) radii can be connected to provide a highly smooth transition.

In an embodiment, the transition portion is purely concave. A concave transition portion has shown particularly advantageous behavior in terms of bending protection.

In another embodiment, the transition portion is purely convex. In certain embodiments, also a convex shape of the rounding may provide an improvement in terms of bending robustness.

In still another embodiment, the transition portion is partially concave and partially convex. Such a partially concave and partially convex transition portion provides a smooth and nevertheless load resistant transition between rigid portion and flexible portion.

In an embodiment, the transition portion has a rounding in a plane parallel to the layer structures. More precisely, the transition portion may have the rounding at at least one edge (in particular at two opposing edges) of the flexible portion in a plane parallel to each of the layer structures. Highly advantageously, the rounding may be provided within a plane which is parallel to the layer structures. In other words, a plan view on the planar component carrier with the paper plane corresponding to the main surfaces of the component carrier may show the curvature or rounding within the paper plane rather than perpendicular thereto. In particular, such a rounding has turned out to improve the bending characteristics of the partially flexible and partially rigid component carrier.

In an embodiment, the transition portion is configured so that a minimum width of the flexible portion is smaller than a (for instance constant or minimum) width of the rigid portion. In other words, the flexible portion may have a smaller width in the previously described paper plane than the rigid portion. Such a geometry has turned out to provide particularly good properties in terms of bending resistance.

In an embodiment, electrically insulating material of the second electrically insulating layer structures of the flexible portion comprises a resin, in particular an epoxy resin, optionally comprising reinforcing structures, in particular glass fibres or glass spheres, for instance is made of FR4 material. Hence, the dielectric material of at least part of the component carrier in the flexible region may be prepreg.

In an embodiment, electrically insulating material of the first electrically insulating layer structures of the flexible portion comprises at least one of polyimide (PI), polyamide (PA), and ABF (Ajinomoto Build-up Film). Thus, at least part of the dielectric material of the flexible portion may be made of intrinsically flexible dielectric materials.

In an embodiment, the component carrier comprises a further rigid portion comprising a third stack having at least one third electrically conductive layer structure and/or at least one third electrically insulating layer structure, wherein a further transition portion at an interface between the further rigid portion and the flexible portion is rounded. For instance, it is possible that one flexible portion is sandwiched in between two rigid portions. At one or both transition portions between the two rigid portions and the flexible portion, a rounding may be provided. In particular, the flexible portion may be rounded at both opposing interfaces towards each of the rigid portions.

In an embodiment, in a plan view of the component carrier in a viewing direction along a stacking direction of the layer structures of the stacks, a kink is provided at a connection point between the rigid portion and the flexible portion. A discontinuous kink at the mentioned position has turned out to be not critical in terms of bending failure.

In an embodiment, in a plan view of the component carrier in a viewing direction along a stacking direction of the layer structures of the stacks, the flexible portion has a kink-free edge. Thus, a trajectory defining an exterior edge of the flexible portion may be free of a discontinuity. It has turned out that such a geometry promotes the resistance against bending failure.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias as through hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) or a photoimageable or dry-etchable organic material like epoxy-based build-up material (such as epoxy-based build-up film) or polymer compounds like polyimide, polybenzoxazole, or benzocyclobutene-functionalized polymers.

In an embodiment, at least one of the at least one electrically insulating layer structure comprises at least one of the group consisting of resin (such as reinforced or non-reinforced resins, for instance epoxy resin or bismaleimide-triazine resin), cyanate ester resin, polyphenylene derivate, glass (in particular glass fibers, multi-layer glass, glass-like materials), prepreg material (such as FR-4 or FR-5), polyimide, polyamide, liquid crystal polymer (LCP), epoxy-based build-up film, polytetrafluoroethylene (PTFE, Teflon), a ceramic, and a metal oxide. Reinforcing structures such as webs, fibers or spheres, for example made of glass (multilayer glass) may be used as well. Although prepreg particularly FR4 are usually preferred for rigid PCBs, other materials in particular epoxy-based build-up film or photoimageable dielectric material may be used as well. For high frequency applications, high-frequency materials such as polytetrafluoroethylene, liquid crystal polymer and/or cyanate ester resins, low temperature cofired ceramics (LTCC) or other low, very low or ultra-low DK materials may be implemented in the component carrier as electrically insulating layer structure.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material such as graphene.

At least one component, which can be optionally surface mounted on and/or embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an optical element (for instance a lens), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a substrate, an interposer or a further component carrier, for example in a board-in-board configuration. The component may be surface mounted on the component carrier and/or may be embedded in an interior thereof. Moreover, also other components, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 shows a plan view of a partially rigid and partially flexible component carrier, configured as semi-flex component carrier, before bending according to an exemplary embodiment of the invention.
Figure 2 illustrates a side view of the component carrier of Figure 1 before bending.
Figure 3 illustrates the component carrier of Figure 1 and Figure 2 in a further side view during bending.
Figure 4 illustrates in a bottom portion results of finite element simulations concerning bending stress of various partially rigid and partially flexible component carriers shown in a top portion of Figure 4.
Figure 5 shows bending stress of a detail of a conventional partially rigid and partially flexible component carrier according to Figure 4.
Figure 6 shows bending stress of a detail of a partially rigid and partially flexible component carrier with circular rounding according to an exemplary embodiment of the invention of Figure 4.
Figure 7 shows bending stress of a detail of a partially rigid and partially flexible component carrier with double-radius rounding according to an exemplary embodiment of the invention of Figure 4.
Figure 8 shows a model illustrating a component carrier having a rigid portion and a flexible portion and being subject to a bending simulation using finite elements.
Figure 9 illustrates different bending radii at a respective transition portion of a partially flexible and partially rigid component carrier used for the finite element simulation according to Figure 8.
Figure 10 illustrates diagrams indicating bending stress, as obtained from a finite element analysis, for different bending radii at a respective transition portion of partially flexible and partially rigid component carriers according to exemplary embodiments of the invention.
Figure 11 shows a plan view of a partially rigid and partially flexible component carrier according to another exemplary embodiment of the invention configured as rigid-flex component carrier.
Figure 12 illustrates a side view of the component carrier of Figure 11.
Figure 13 illustrates side views of component carriers according to exemplary embodiments of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

The present invention is based on the finding that bending failure in conventional partially rigid and partially flexible component carriers usually occurs at a transition portion between the flexible portion and the rigid portion thereof. It has further been found that excessive bending stress is due to locally excessive stress specifically at this critical transition portion, and can be significantly reduced by providing a rounding at an interface between the rigid portion and the flexible portion. In other words, the transition portion may be the position of the partially flexible and partially rigid component carrier at which bending failure predominantly occurs, since this position corresponds to a peak of bending stress. This holds for both steps at the interface between flexible and rigid portion as well as a continuous transition.

According to an exemplary embodiment of the invention, a transition portion between a rigid portion and a flexible portion of a partially flexible and partially rigid component carrier is provided with a rounding, in particular a circular rounding. Preferably, the transition between the rigid portion and the flexible portion may be provided with a rounding in accordance with a very small rounding radius. In particular, the transition portion has an interface between flexible portion and rigid portion which reduces the stress in this region and, in particular, avoids stress peaks. The latter may result in a bending failure after one time bending or, even more pronounced, after multiple bending events. Simulations have confirmed that rounding the transition portion between rigid portion and flexible portion may significantly reduce the risk of bending failure at the critical transition portion.

This holds also for the case that the one or more rigid portions are made of another material (for instance FR4) as compared to one or more materials (such as ABF, polyamide, polyimide) of the flexible portion connected therewith. The latter example may relate to a rigid-flex component carrier in which multiple bending events may occur due to the reversible bending characteristics of a rigid-flex component carrier.

However, the improvement of bending robustness in the interface region is also particularly pronounced in a semi-flex-component carrier in which an increased flexibility or elasticity in the flexible portion compared with the one or more adjacent rigid portions is due to (or only due to) a reduced thickness in the flexible portion in comparison with the rigid portion(s). In a semi-flex-component carrier, bending occurs usually only once, and thereafter the semi-flex component carrier may remain permanently in the bent configuration.

According to an exemplary embodiment of the invention, a curved radius may be provided for a rigid-flexible-transition portion of a bendable component carrier (in particular printed circuit board, PCB). It turned out that the risk of failure during the bending operation may be significantly reduced due to the provision of a transition portion with a geometry in accordance with a radius or an S-shape between a rigid portion and a flexible portion of the component carrier. A proof of actual stress lowering by rounding the transition portion has been found by finite element simulation. These simulations have confirmed that the risk of failure between rigid and flexible PCB portions during bending operation.

For instance, a thickness difference between a rigid portion and a flexible portion may be formed by embedding a release layer in a stack provided for forming the flexible portion. For instance, the release layer may be printed in form of a waxy compound or may be made of another material being poorly adhesive with respect to other materials of the stack. Thereafter, one or more further electrically conductive layer structures and/or one or more electrically insulating layer structures may be connected to the stack to thereby embed the release layer within the stack. Thereafter, a circumferential cutting trench may be cut in the stack to extend vertically up to the release layer. Cutting trench may for example be formed by laser cutting or by mechanically cutting. Thereby, a stack piece is separated from a rest of the stack. Laterally, said piece is separated by the cutting trench. At a bottom side, said piece is separated by the non-adhesive release layer. Subsequently, a blind hole-type opening may be formed in the stack by removing said cap-shaped piece from the stack. The piece is delimited at a bottom side by the release layer and laterally by the circumferential or annular trench. Thereafter, the release layer may be removed, for instance by stripping. The flexible portion with locally reduced thickness may then be obtained where the piece has been removed. For example, the formation of a radius in the transition portion of the partially flexible component carrier may be formed by deep routing in the transition portion. Hence, inserting a rounding such as a radius or an S-shaped radius in the transition portion may be carried out easily.

In an embodiment, a thickness difference may be established between the rigid portion and the flexible portion. This may be accomplished by creating a recess in the flexible portion compared with the rigid portion. Such a recess may be created on one or both opposing main surfaces of the layer stack(s) constituting the rigid portion and the flexible portion. For instance, a sequence rigid-flexible-rigid may be substantially U-shaped or may be substantially H-shaped in a side or cross-sectional view. In other words, a step from a rigid portion to a flexible portion up to a further rigid portion may be provided on one or both of the upper side and the lower side of the layer stacks. Correspondingly, there may be release layers on both sides for defining the cut-outs.

Hence, it has been found that a bendable section of a component carrier can easily fail due to the bending operation into the final position. However, it has been found that inserting a radius or an S-shaped radius to the corner area of the flexible portion and the rigid portion can significantly reduce the stress situation in the corners and therefore dramatically decreases the risk of failure. A proof of this positive stress lowering effect has been executed by the below described finite element (FE) simulation. As a result, a significantly decreased risk of failure can be obtained in an outer corner between a rigid and a flexible PCB part.

A highly reasonable range for a radius defining the rounding between the flexible portion and the rigid portion may be a range from 0.1 mm to 6 mm, in particular a range from 3 mm to 6 mm. However, also relatively small values of the radius, for instance in the range from 0.1 mm to 1 mm may be a highly appropriate choice which results in a highly compact configuration. In particular, a detailed selection of a proper dimensioning of the rounding may be made in accordance with a specific PCB design.

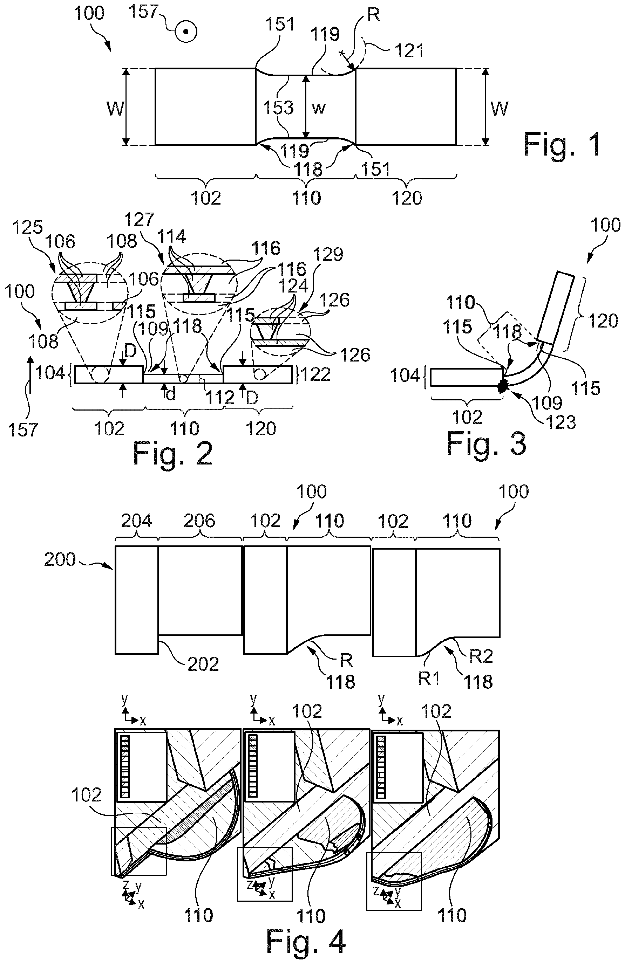

**Figure 1** shows a plan view of a partially rigid and partially flexible component carrier 100, configured as semi-flex component carrier, according to an exemplary embodiment of the invention. **Figure 2** illustrates a side view of the component carrier 100 of Figure 1. **Figure 3** illustrates said component carrier 100 in a further side view during bending.

The illustrated component carrier 100 comprises an exterior rigid portion 102, a central flexible portion 110 and a further exterior rigid portion 120. The central flexible portion 110 is arranged between rigid portion 102 and rigid portion 120. In other words, the flexible portion 110 is arranged between or is enclosed by different non-bendable sections or rigid portions 102, 120. As shown in Figure 2 and Figure 3, the component carrier 100 has a locally decreased thickness, d, in the flexible portion 110 as compared to a larger thickness, D, in each of the rigid portions 102, 120. This difference in thickness is created by a cavity 109 in the flexible portion 110 which can be formed by removing one or multiple layer structures selectively in the flexible portion 110, but not in the rigid portions 102, 120 (for instance by milling or by applying the concept of a release layer, as described above).

Thus, the component carrier 100 according to Figure 1 to Figure 3 is configured as semi-flex component carrier 100 in which electrically insulating material (for instance FR4) of the rigid portions 102, 120 and of the flexible portion 110 is the same. The flexible property of the flexible portion 110 compared to the rigid character of the rigid portions 102, 120 may thus be the consequence of the local thinning in the flexible portion 110 compared to the rigid portions 102, 120. Usually, a semi-flex component carrier 100 is bent once and then remains in the bent configuration.

More specifically, first rigid portion 102 comprises a first laminated layer stack 104 having first electrically conductive layer structures 106 and first electrically insulating layer structures 108 (compare detail 125). Flexible portion 110 comprises a second laminated layer stack 112 having second electrically conductive layer structures 114 and second electrically insulating layer structures 116 (compare detail 127). Second rigid portion 120 comprises a third laminated layer stack 122 having third electrically conductive layer structures 124 and third electrically insulating layer structures 126 (compare detail 129). For example, the electrically conductive layer structures 106, 114, 124 may comprise patterned copper foils (and optionally one or more vertical through connections, for example copper filled laser vias). The electrically insulating layer structure 108, 116, 126 may comprise a resin (such as epoxy resin), optionally comprising reinforcing particles therein (for instance glass fibers or glass spheres). For instance, the electrically insulating layer structures 108, 116, 126 may be made of prepreg or FR4. The layer structures 106 and 108, 114 and 116, and 124 and 126, respectively, may be connected by lamination, i.e. the application of pressure and/or heat.

As shown in the plan view of Figure 1, transition portions 118 at interfaces between each of the rigid portions 102, 120 and the flexible portion 110 are rounded. The side views of Figure 2 and Figure 3 show a step 115 in the transition portions 118 between the rigid portions 102, 120 and the flexible portion 110 in corners of the cavity 109. As shown in Figure 2, the cavity 109 has a rectangular cross-section with corners in which the respective step 115 is formed. In contrast to this, the plan view of Figure 1 shows a rounding in the transition portions 118 as an interface between the flexible portion 110 and the rigid portions 102, 120. Hence, the rounded transition portions 118 are formed within a plane corresponding to the planes of layer structures 114, 116 of the flexible portion 110. More specifically, the flexible portion 110 has two opposing concave indentations 119 in a plane perpendicular to a layer stacking direction 157 of layer stack 112 defining said flexible portion 110. As shown, the transition portion 118 has roundings arranged at both opposing edges 153 of the flexible portion 110 in the plane parallel to each of the layer structures 106, 108, 114, 116, 124, 126. As a result of the formation of the indentations 119, the transition portions 118 are configured so that a minimum width w of the flexible portion 110 is smaller than a (in the shown embodiment constant) width W of the rigid portions 102, 120, as shown in Figure 1. Opposing end sections of the flexible portion 110 being connected to the rigid portions 102, 120, respectively, form roundings in the transition portions 118 in the plan view of the component carrier 100. In contrast to this, vertical steps 115 may be formed in the side view of the component carrier 100 (compare Figure 2 and Figure 3), i.e. in a viewing direction within the planes of layer structures 114, 116. Hence, Figure 1 to Figure 3 show that the transition portion 118 has a respective rounding in a plane parallel to the layer structures of stacks 104, 112, 122.

According to Figure 1, all four transition portions 118 between the rigid portions 102, 120 on the one hand and the flexible portion 110 on the other hand are rounded. It is alternatively also possible that only one or only two transition portions 118 between the rigid portion 102 and the flexible portion 110 is rounded, and/or that only one or only two transition portions 118 between the rigid portion 120 and the flexible portion 110 is rounded.

While the rigid portions 102, 120 and the flexible portion 110 comprise substantially the same materials (predominantly copper, resin and glass fibers), the rigid portions 102, 120 are rendered rigid by providing them with a larger vertical thickness D than the flexible portion 110 (having a thickness d<D). The flexible portion 110 is hence rendered flexible in view of its smaller thickness d.

In the corner region or transition portions 118 of the component carrier 100, the exerted stress or force may be maximum during bending. However, the breakage force in the transition portions 118 may be very small due to the provision of the roundings visible in the viewing direction perpendicular to the stacked layer structures of both the rigid portions 102, 120 and the flexible portion 110 in the non-bent state.

The rigid portions 102, 120 and the flexible portion 110 may share one or more common continuous electrically insulating layer structure and/or one or more common continuous electrically conductive layer structure. More specifically, providing at least one first electrically conductive layer structure 106 and at least one second electrically conductive layer structure 114 and at least one third electrically conductive layer structure 124 to form a common electrically conductive layer structure extending along substantially the entire length direction of the component carrier 100 may also result in proper bending properties. Additionally or alternatively, at least one first electrically insulating layer structure 108 and at least one second electrically insulating layer structure 116 and at least one third electrically insulating layer structure 126 forming a common electrically insulating layer structure may additionally promote stability of the component carrier 100 as a whole and may therefore provide a further protection against bending failure.

As indicated by a partial circle 121 in Figure 1, a respective transition portion 118 may have a rounding defined by a radius R. Such a circularly rounded transition portion 118 may be simply manufacturable. In one embodiment, the radius R may be smaller than 1 mm or may be even smaller than 0.5 mm. With a relatively small radius R, the geometrical impact of the bending failure protection structure on the construction of the component carrier 100 as a whole is very small. However, it is also possible that radius R is larger than 1 mm, in particular larger than 3 mm. A relatively large radius R may have a large impact on the bending failure protection.

According to Figure 1, the rounding at each of the transition portions 118 is concave. However, the rounding may be alternatively convex, or a combination of a concave section and a convex section.

As shown in Figure 3, a most critical bending point 123 in the transition portion 118 denotes a position at which a maximum bending force or bending stress occurs during bending. Inserting transition portions 118 with rounding radius R between flexible portion 110 and rigid portions 102, 120 may reduce a risk of bending failure by reducing the mechanical load exerted to said transition portion 118 close to bending point 123 during bending as shown in Figure 3.

Summarizing, Figure 1 shows a plan view of the component carrier 100 and shows transitions between the central flexible portion 110 and the two exterior rigid portions 102, 120 of the partially flexible and partially rigid component carrier 100 of Figure 1 for load reduction upon bending. More specifically, the illustrated rounding in the transition portions 118 may be provided on both opposing sides of the flexible portion 110, i.e. at each of the interfaces towards each of the rigid portions 102, 120. In sum, four curved sections are provided according to Figure 1. By rounding said interfaces, load peaks during bending at a respective interface between the flexible portion 110 and the rigid portions 102, 120 may be reduced and the load may be spatially balanced out or equilibrated. In other words, a better load distribution over the transition portions 118 may be accomplished by said rounding. This may decrease the risk of failure of flexible PCB sections during bending. Figure 3 illustrates such a bending procedure in a side view. In other words, a circular (or an S-shaped) transition portion 118 has turned out to reduce the risk of failure in the transition zone.

Figure 2 (without bending) and Figure 3 (during or after bending) shows side views of the component carrier 100 according to Figure 1 prior to bending and during or after bending. Reference numeral 123 indicates a position at which conventionally excessive or maximum bending stress may occur, which may result in a bending failure, such as a breakage, of the partially rigid and partially flexible component carrier 100. However, due to the roundings implemented in the interface or transition portions 118 according to Figure 1, it has turned out that bending stress particular at the critical position denoted with reference sign 123 can be significantly reduced. Thus, a more reliable component carrier 100 with nevertheless partially flexible properties may be obtained with low effort.

As shown, in the plan view of the component carrier 100 a kink 151 is provided at a respective connection point between the respective rigid portion 102, 120 and the flexible portion 110. Moreover, in the plan view of the component carrier 100 the flexible portion 110 has two opposing kink-free edges 153. The viewing direction perpendicular to the paper plane of Figure 1 extends along a stacking direction 157 of the layer structures 106, 108, 114, 116, 124, 126 of the stacks 104, 112, 122.

A bottom portion of **Figure 4** shows the results of finite element simulations concerning bending stress of various partially rigid and partially flexible component carriers 100, 200 shown in a top portion of Figure 4. The illustration in the top portion of Figure 4 relates to a 0° bend position, i.e. without bending of the respective component carrier 100, 200. The illustration in the bottom portion of Figure 4 relates to a 90° bend position, i.e. after extensive bending of the respective component carrier 100, 200 in the respective transition portion 202, 118.

More specifically, the top portion of Figure 4 shows plan views of partially rigid and partially flexible component carriers 200, 100 with a conventional transition portion 202 on the left-hand side and with transition portions 118 according to exemplary embodiments of the invention in the center and on the right-hand side.

The plan view (corresponding to Figure 1) of the conventional component carrier 200 on the left-hand side of Figure 4 shows a rigid portion 204 connected to a flexible portion 206 with a discontinuous vertical step in between.

The plan view (corresponding to Figure 1 as well) of the component carrier 100 according to an exemplary embodiment in the central portion of Figure 4 shows a rigid portion 102 connected to a flexible portion 110 with a circular rounding defined by a radius R in a transition portion 118 in between.

The plan view (corresponding to Figure 1 as well) of the component carrier 100 according to another exemplary embodiment on the right-hand side of Figure 4 shows a rigid portion 102 connected to a flexible portion 110 with a combined convex-concave double-circular rounding defined by radii R1, R2 in a transition portion 118 in between. Said transition portion 118 is thus defined by a first radius R1 followed by a second radius R2. The first radius R1 defines a convex rounding portion, whereas the second radius R2 defines a concave rounding portion of the transition portion 118. The sections corresponding to the first radius R1 and the second radius R2 are connected so as to form a continuous rounding profile without discontinuity. The right-hand side shows a bending by two radii R1, R2, wherein radius R1 defines a convex rounding and radius R2 defines a concave rounding.

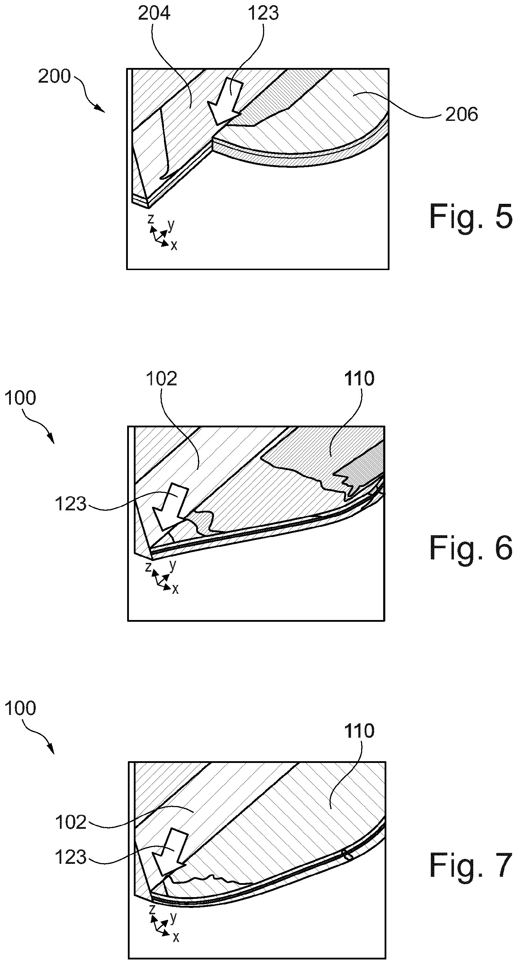

The lower portion of Figure 4 shows the results of an investigation of the three embodiments shown on the top side of Figure 4 by finite element simulations. Hence, the bottom portion of Figure 4 shows a result of simulations for the three scenarios illustrated in the top portion of Figure 3. For each of the illustrations in the bottom portion of Figure 4, a more detailed view is provided in Figure 5 to Figure 7:

**Figure 5** shows bending stress of a detail of the conventional partially rigid and partially flexible component carrier 200 according to the left-hand side of Figure 4. Higher bending stress occurs in the corners compared to the details according to Figure 6 and Figure 7. **Figure 6** shows bending stress of a detail of the partially rigid and partially flexible component carrier 100 with circular rounding according to the exemplary embodiment of the invention of the central portion of Figure 4. **Figure 7** shows bending stress of a detail of the partially rigid and partially flexible component carrier 100 with a combined convex-concave rounding according to the exemplary embodiment of the invention according to the right-hand side of Figure 4. Both the finite element simulation results of Figure 6 and Figure 7 show lower bending stress compared to Figure 5 and thus an improved protection against bending failure. In particular in the critical region according to reference sign 123, stress reduction may be achieved by the configurations of Figure 6 and Figure 7 compared of the configuration of Figure 5.

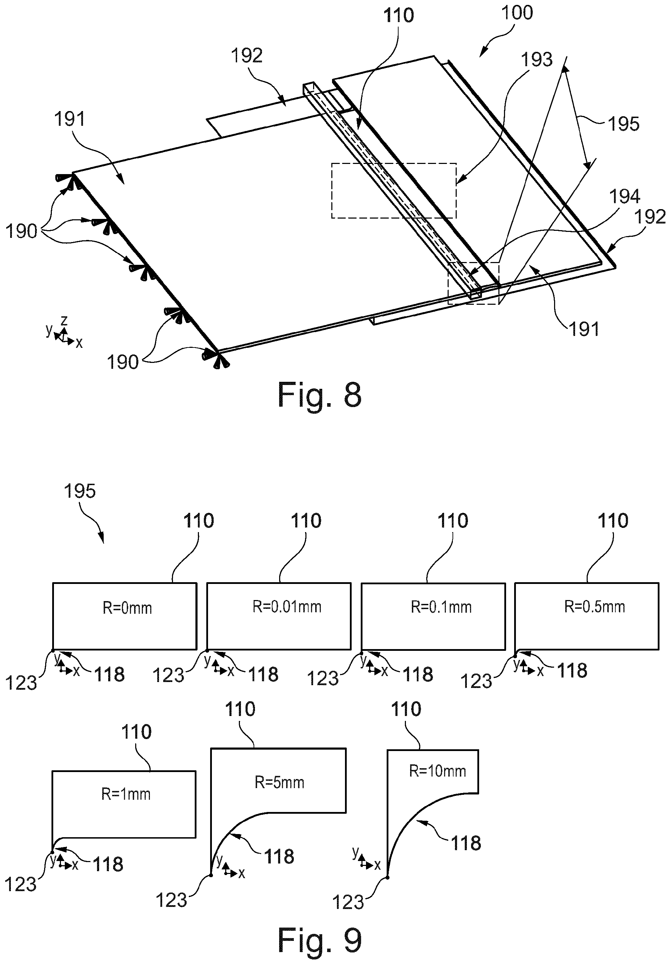

**Figure 8** shows a theoretical model illustrating a component carrier 100 having rigid portions 102, 120 and a flexible portion 110 in between and being bent according to an exemplary embodiment of the invention.

In the model according to Figure 8 used as a basis for the finite element analysis, reference sign 190 denotes fixed degrees of freedom. Reference sign 191 denotes a bottom board. Reference sign 192 denotes a bottom jig. Reference sign 193 denotes a gear which drives the kinematics of the model. Reference sign 194 shows a spacer for pinning the board to the bottom jig.

Reference sign 195 shows a detail which is shown in Figure 9 for different value of a radius R: More specifically, **Figure 9** illustrates different bending radii R at a respective transition portion 118 of a partially flexible and partially rigid component carrier 100 according to exemplary embodiments of the invention. As shown, a range of radii for different bending angles of the finite element model are R=0 mm, R=0.01 mm, R=0.1 mm, R=0.5 mm, R=1 mm, R=5 mm and R=10 mm.

A position for stress extraction is denoted again with reference sign 123. A three-dimensional dynamic implicit simulation has been carried out. The simulation is based on a homogenized PCB to represent the physical effects. Dielectric layer materials which have been used for the simulation are FR4 (i.e. glass fiber reinforced epoxy), resin sheets with no glass fibre reinforced thermoset (such as ABF, etc.), and polyimide.

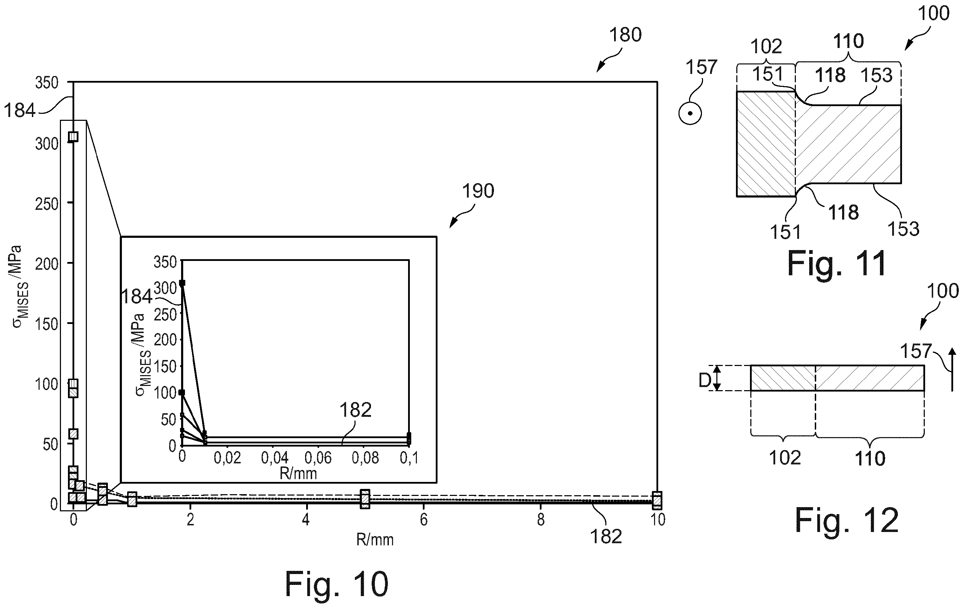

Thus, Figure 8 shows a scenario used as a model for the simulations. As can be shown in Figure 9, the simulation has been carried out for very different values of the bending radius R. In the described radius range for different bending angles results concerning stress extracted in dielectric layer has been simulated. The results shown in Figure 10 illustrate that, for all materials, the bending stress is always significantly lower in the presence of a radius. Interestingly, even a small radius decreases the stress in the corner significantly.

**Figure 10** illustrates diagrams 180, 190 indicating bending stress according to different bending radii R at a respective transition portion 118 of a partially flexible and partially rigid component carrier 100 according to exemplary embodiments of the invention. In other words, Figure 10 illustrates results of the above-described finite element analysis.

Figure 10 illustrates a first diagram 180 showing the result of the above-described simulations. Diagram 180 has an abscissa 182 on which the radius R of the rounding in the transition portion 118 is illustrated in millimeters. Along an ordinate 184, the mechanical stress σ_{MISES} is plotted in MPa. As can be seen from a number of simulation points in the diagram 180, a significant reduction of the stress may be obtained already at relatively low radii R. A second diagram 190, which is plotted inside of diagram 180 shows details of simulation points for very small radii R. It can be seen that a reduction of the bending stress can be obtained by configuration of the transition portion 118 with a rounding according to exemplary embodiments of the invention.

Hence, the various embodiments of Figure 9 with R≠0 all have a transition portion 118 being rounded in such a way that said rounding reduces a bending stress at bending point 123 at the transition portion 118 as compared to a non-rounded transition (in particular a vertical transition with R=0) between the rigid portion 102 and the flexible portion 110.

**Figure 11** shows a plan view (corresponding to Figure 1) of a partially rigid and partially flexible component carrier 100 according to another exemplary embodiment of the invention configured as rigid-flex component carrier. **Figure 12** illustrates a side view (corresponding to Figure 2) of the component carrier 100 of Figure 11.

In contrast to Figure 1 to Figure 3, the component carrier 100 according to Figure 11 in Figure 12 is configured as a rigid-flex component carrier in which electrically insulating material of the flexible portion 110 is different from electrically insulating material of the rigid portion 102. The electrically insulating material of the rigid portion 102 may for instance be FR4. The electrically insulating material of the flexible portion 110 may for instance be an intrinsically flexible material such as polyimide, polyamide, etc. As can be seen from the side view of Figure 12, the component carrier 100 may hence have a homogeneous thickness D. The component carrier 100 may be bent multiple times at the transition portion 118 which is provided with a radius-type rounding, as shown in Figure 11.

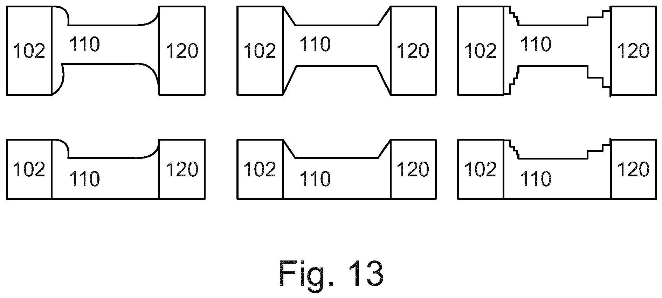

**Figure 13** illustrates side views of component carriers 100 according to exemplary embodiments of the invention. In a top view, these component carriers 100 may be configured in a way as shown in Figure 1.

As can be taken from Figure 13, in a side view of the component carriers 100 in a viewing direction perpendicular to a stacking direction 157 of the layer structures of the stacks 104, 112, 122 (i.e. in a viewing direction corresponding to Figure 2), the flexible portion 110 may have one recess with respect to the rigid portions 102, 120 in the lower row of Figure 13. In the upper row of Figure 13, two recesses are provided on both opposing main surfaces of the flexible portion 110 with respect to the rigid portions 102, 120.

Moreover, in the side view of the component carrier 100 in a viewing direction perpendicular to the stacking direction 157 of the layer structures of the stacks 104, 112, 122, a transition between a respective one of the rigid portions 102, 120 and the flexible portion 110 may have different shapes:
- the transition may comprise a rounding, such as a circular rounding, a convex rounding and/or a concave rounding (see left hand side of Figure 13): this may have a highly advantageous effect on the reduction of bending stress
- the transition may comprise a slanted or tapering sidewall (see central region of Figure 13): this may also reduce to a certain extent bending stress (slanted sidewalls may be formed for example by cavity milling using a laser, wherein a horizontal extension of the slanted sidewalls may be for instance in a range from 10 µm to 15 µm)
- multiple steps forming a stair-type structure (see right hand side of Figure 13): this may be manufactured for instance by multi-stage deep milling

Thus, the transition in the side view can for instance be partially rounded, tapering, provided with slanted sides, or with several steps (i.e. in a multistep arrangement). Adjustment of this geometry may be made depending on the fabrication process (for instance the use of release layer, cutting tools, etc.).

Also a vertical step can be provided at a transition between a rigid portion and a flexible portion, see Figure 2.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A partially rigid and partially flexible component carrier (100), wherein the component carrier (100) comprises:
a rigid portion (102) comprising a first stack (104) having at least one first electrically conductive layer structure (106) and/or at least one first electrically insulating layer structure (108);
a flexible portion (110) comprising a second stack (112) having at least one second electrically conductive layer structure (114) and/or at least one second electrically insulating layer structure (116);
wherein a transition portion (118) at an interface between the rigid portion (102) and the flexible portion (110) is rounded for reducing bending stress.

2. The component carrier (100) according to claim 1, wherein at least one of the at least one first electrically conductive layer structure (106) and at least one of the at least one second electrically conductive layer structure (114) form a common coplanar electrically conductive layer structure.

3. The component carrier (100) according to claim 1 or 2, wherein at least one of the at least one first electrically insulating layer structure (108) and at least one of the at least one second electrically insulating layer structure (116) form a common coplanar electrically insulating layer structure.

4. The component carrier (100) according to any of claims 1 to 3, configured as rigid-flex component carrier in which electrically insulating material of the flexible portion (110) is different from electrically insulating material of the rigid portion (102) and/or in which a thickness (D) of the flexible portion (110) and of the rigid portion (102) is the same.

5. The component carrier (100) according to any of claims 1 to 4, configured as semi-flex component carrier in which electrically insulating material of the rigid portion (102) and of the flexible portion (110) is the same and/or in which a thickness (d) of the flexible portion (110) is smaller than a thickness (D) of the rigid portion (102).

6. The component carrier (100) according to any of claims 1 to 5, wherein the transition portion (118) has a rounding defined by a radius (R).

7. The component carrier (100) according to claim 6, comprising at least one of the following features:
wherein the radius (R) is smaller than 1 mm, in particular smaller than 0.5 mm;
wherein the radius (R) is larger than 0.1 mm.

8. The component carrier (100) according to any of claims 1 to 7, wherein the transition portion (118) is defined by a region corresponding to a first radius (R1) connected to another region corresponding to a second radius (R2), in particular to thereby form one of an S-shape, and a continuous convex-concave shape.

9. The component carrier (100) according to any of claims 1 to 8, comprising at least one of the following features:
wherein the transition portion (118) is concave;
wherein the transition portion (118) is convex;
wherein the transition portion (118) is partially concave and partially convex;
wherein the transition portion (118) has the rounding at at least one edge (153) of the flexible portion (110) in a plane parallel to each of the layer structures (106, 108, 114, 116);
wherein, in a plan view of the component carrier (100) in a viewing direction along a stacking direction (157) of the layer structures (106, 108, 114, 116) of the stacks (104, 112), the transition portion (118) is configured so that a minimum width (w) of the flexible portion (110) is smaller than a width (W) of the rigid portion (102);
wherein electrically insulating material of the flexible portion (110) comprises a resin, in particular an epoxy resin, optionally comprising reinforcing structures, in particular glass fibres or glass spheres, for instance is made of FR4 material;
wherein electrically insulating material of the flexible portion (110) comprises at least one of polyimide, polyamide, and ABF;
comprising a further rigid portion (120) comprising a third stack (122) having at least one third electrically conductive layer structure (124) and/or at least one third electrically insulating layer structure (126), wherein a further transition portion (118) at an interface between the further rigid portion (120) and the flexible portion (110) is rounded;
wherein, in a plan view of the component carrier (100) in a viewing direction along a stacking direction (157) of the layer structures (106, 108, 114, 116) of the stacks (104, 112), a kink (151) is provided at a connection point between the rigid portion (102) and the flexible portion (110).

10. The component carrier (100) according to any of claims 1 to 9, wherein, in a plan view of the component carrier (100) in a viewing direction along a stacking direction (157) of the layer structures (106, 108, 114, 116) of the stacks (104, 112), the flexible portion (110) has a kink-free edge (153).

11. The component carrier (100) according to any of claims 1 to 10, wherein in a side view of the component carrier (100) in a viewing direction perpendicular to a stacking direction (157) of the layer structures (106, 108, 114, 116) of the stacks (104, 112), a transition between the rigid portion (102) and the flexible portion (110) has at least one of the following shapes:
• a vertical step;
• a slanted or tapering sidewall;
• a rounding, in particular at least one of a circular rounding, a convex rounding and a concave rounding; and
• multiple steps.

12. The component carrier (100) according to any of claims 1 to 11, wherein in a side view of the component carrier (100) in a viewing direction perpendicular to a stacking direction (157) of the layer structures (106, 108, 114, 116) of the stacks (104, 112), the flexible portion (110) has a recess with respect to the rigid portion (102) on one or both opposing main surfaces.

13. The component carrier (100) according to any of claims 1 to 12, wherein the transition portion (118) is rounded in such a way that the rounding reduces a bending stress at a bending point (123) at the transition portion (118) as compared to a non-rounded, in particular vertical, transition between the rigid portion (102) and the flexible portion (110).

14. The component carrier (100) according to any of claims 1 to 13, comprising at least one of the following features:
wherein at least one of the at least one first electrically conductive layer structure (106) and the at least one second electrically conductive layer structure (114) comprises at least one of the group consisting of copper, aluminum, nickel, silver, gold, palladium, and tungsten, any of the mentioned materials being optionally coated with supra-conductive material such as graphene;
wherein at least one of the at least one first electrically insulating layer structure (108) and the at least one second electrically insulating layer structure (116) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based build-up material, polytetrafluoroethylene, a ceramic, and a metal oxide;
wherein the component carrier (100) is shaped as a plate;
wherein the component carrier (100) is configured as one of the group consisting of a printed circuit board, and a substrate;
wherein the component carrier (100) is configured as a laminate-type component carrier.

15. A method of manufacturing a partially rigid and partially flexible component carrier (100), wherein the method comprises:
forming a rigid portion (102) comprising a first stack (104) having at least one first electrically conductive layer structure (106) and/or at least one first electrically insulating layer structure (108);
forming a flexible portion (110) comprising a second stack (112) having at least one second electrically conductive layer structure (114) and/or at least one second electrically insulating layer structure (116); and
forming a transition portion (118) at an interface between the rigid portion (102) and the flexible portion (110) with a rounding for reducing bending stress.

## Amended claims

### Amended claims in accordance with Rule 137(2) EPC.

1. A partially rigid and partially flexible component carrier (100), wherein the component carrier (100) comprises:
a rigid portion (102) comprising a first stack (104) having at least one first electrically conductive layer structure (106) and at least one first electrically insulating layer structure (108);
a flexible portion (110) comprising a second stack (112) having at least one second electrically conductive layer structure (114) and/or at least one second electrically insulating layer structure (116);
**characterized in that**,
in a plan view of the component carrier (100) in a viewing direction along a stacking direction (157) of the layer structures (106, 108, 114, 116) of the stacks (104, 112), a transition portion (118) at an interface between the rigid portion (102) and the flexible portion (110) is rounded for reducing bending stress.

2. The component carrier (100) according to claim 1, wherein at least one of the at least one first electrically conductive layer structure (106) and at least one of the at least one second electrically conductive layer structure (114) form a common coplanar electrically conductive layer structure.

3. The component carrier (100) according to claim 1 or 2, wherein at least one of the at least one first electrically insulating layer structure (108) and at least one of the at least one second electrically insulating layer structure (116) form a common coplanar electrically insulating layer structure.

4. The component carrier (100) according to any of claims 1 to 3, configured as rigid-flex component carrier in which electrically insulating material of the flexible portion (110) is different from electrically insulating material of the rigid portion (102) and/or in which a thickness (D) of the flexible portion (110) and of the rigid portion (102) is the same.

5. The component carrier (100) according to any of claims 1 to 4, configured as semi-flex component carrier in which electrically insulating material of the rigid portion (102) and of the flexible portion (110) is the same and/or in which a thickness (d) of the flexible portion (110) is smaller than a thickness (D) of the rigid portion (102).

6. The component carrier (100) according to any of claims 1 to 5, wherein the transition portion (118) has a rounding defined by a radius (R).

7. The component carrier (100) according to claim 6, comprising at least one of the following features:
wherein the radius (R) is smaller than 1 mm, in particular smaller than 0.5 mm;
wherein the radius (R) is larger than 0.1 mm.

8. The component carrier (100) according to any of claims 1 to 7, wherein the transition portion (118) is defined by a region corresponding to a first radius (R1) connected to another region corresponding to a second radius (R2), in particular to thereby form one of an S-shape, and a continuous convex-concave shape.

9. The component carrier (100) according to any of claims 1 to 8, comprising at least one of the following features:
wherein the transition portion (118) is concave;
wherein the transition portion (118) is convex;
wherein the transition portion (118) is partially concave and partially convex;
wherein the transition portion (118) has the rounding at at least one edge (153) of the flexible portion (110) in a plane parallel to each of the layer structures (106, 108, 114, 116);
wherein, in a plan view of the component carrier (100) in a viewing direction along a stacking direction (157) of the layer structures (106, 108, 114, 116) of the stacks (104, 112), the transition portion (118) is configured so that a minimum width (w) of the flexible portion (110) is smaller than a width (W) of the rigid portion (102);
wherein electrically insulating material of the flexible portion (110) comprises a resin, in particular an epoxy resin, optionally comprising reinforcing structures, in particular glass fibres or glass spheres, for instance is made of FR4 material;
wherein electrically insulating material of the flexible portion (110) comprises at least one of polyimide, polyamide, and ABF;
comprising a further rigid portion (120) comprising a third stack (122) having at least one third electrically conductive layer structure (124) and/or at least one third electrically insulating layer structure (126), wherein a further transition portion (118) at an interface between the further rigid portion (120) and the flexible portion (110) is rounded;
wherein, in a plan view of the component carrier (100) in a viewing direction along a stacking direction (157) of the layer structures (106, 108, 114, 116) of the stacks (104, 112), a kink (151) is provided at a connection point between the rigid portion (102) and the flexible portion (110).

10. The component carrier (100) according to any of claims 1 to 9, wherein, in a plan view of the component carrier (100) in a viewing direction along a stacking direction (157) of the layer structures (106, 108, 114, 116) of the stacks (104, 112), the flexible portion (110) has a kink-free edge (153).

11. The component carrier (100) according to any of claims 1 to 10, wherein in a side view of the component carrier (100) in a viewing direction perpendicular to a stacking direction (157) of the layer structures (106, 108, 114, 116) of the stacks (104, 112), a transition between the rigid portion (102) and the flexible portion (110) has at least one of the following shapes:
• a vertical step;
• a slanted or tapering sidewall;
• a rounding, in particular at least one of a circular rounding, a convex rounding and a concave rounding; and
• multiple steps.

12. The component carrier (100) according to any of claims 1 to 11, wherein in a side view of the component carrier (100) in a viewing direction perpendicular to a stacking direction (157) of the layer structures (106, 108, 114, 116) of the stacks (104, 112), the flexible portion (110) has a recess with respect to the rigid portion (102) on one or both opposing main surfaces.

13. The component carrier (100) according to any of claims 1 to 12, wherein the transition portion (118) is rounded in such a way that the rounding reduces a bending stress at a bending point (123) at the transition portion (118) as compared to a non-rounded, in particular vertical, transition between the rigid portion (102) and the flexible portion (110).

14. The component carrier (100) according to any of claims 1 to 13, comprising at least one of the following features:
wherein at least one of the at least one first electrically conductive layer structure (106) and the at least one second electrically conductive layer structure (114) comprises at least one of the group consisting of copper, aluminum, nickel, silver, gold, palladium, and tungsten, any of the mentioned materials being optionally coated with supra-conductive material such as graphene;
wherein at least one of the at least one first electrically insulating layer structure (108) and the at least one second electrically insulating layer structure (116) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based build-up material, polytetrafluoroethylene, a ceramic, and a metal oxide;
wherein the component carrier (100) is shaped as a plate;
wherein the component carrier (100) is configured as one of the group consisting of a printed circuit board, and a substrate;
wherein the component carrier (100) is configured as a laminate-type component carrier.

15. A method of manufacturing a partially rigid and partially flexible component carrier (100), wherein the method comprises:
forming a rigid portion (102) comprising a first stack (104) having at least one first electrically conductive layer structure (106) and at least one first electrically insulating layer structure (108);
forming a flexible portion (110) comprising a second stack (112) having at least one second electrically conductive layer structure (114) and/or at least one second electrically insulating layer structure (116); and
forming, in a plan view of the component carrier (100) in a viewing direction along a stacking direction (157) of the layer structures (106, 108, 114, 116) of the stacks (104, 112), a transition portion (118) at an interface between the rigid portion (102) and the flexible portion (110) with a rounding for reducing bending stress.
